# EUROPEAN PATENT APPLICATION

(11) **EP 4 644 994 A1**
(43) Date of publication of application: **05.11.2025**
(21) Application number: 24173430.0
(22) Date of filing: 30.04.2024
(51) Int. Cl.: G03F 7/20, G02B 5/22, G01N 21/47

(54) **MODULE FOR A METROLOGY TOOL WITH AN APERTURE WITH SIZE AND/OR SHAPE DEPENDENT ON RADIATION WAVELENGTH**

(71) Applicant: ASML Netherlands B.V., 5500 AH Veldhoven (NL)
(72) Inventor: MATHIJSSEN, Simon, Gijsbert, Josephus, 5500 AH Veldhoven (NL); VARGHESE, Smitha, Susan, Wilton, 06897 CT (US)
(74) Representative: ASML Netherlands B.V.

(57) **Abstract**

A metrology tool for determining one or more parameters of interest (e.g. overlay) of a structure on an object (e.g. a wafer). The metrology tool comprises: a module for at least partially defining an aperture; projection optics; detection optics; and a detector. The module for at least partially defining an aperture is positionable so as to receive a radiation beam and to transmit a modified radiation beam. The projection optics is arranged to project modified radiation output by the module onto a beam spot region in which the structure is positionable. The detection optics is arranged to receive at least a portion of radiation scattered by the structure. The detector is operable to determine one or more parameters from the received scattered radiation. The module is configured such that a size and/or shape of the aperture defined by the module is dependent on a wavelength of the received radiation.

## Description

### FIELD

The present invention relates to a new metrology apparatus or metrology tool. The present invention also relates to a new module for use in a metrology tool and for at least partially defining an aperture in the metrology tool.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.
Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

It may be desirable to provide new metrology apparatus, and components therefor, for determining one or more parameters of a periodic target (for example on a wafer) that at least partially addresses one or more problems associated with known arrangements, whether such problems are identified herein or otherwise.

### SUMMARY

According to a first aspect of the present disclosure there is provided a metrology tool for determining one or more parameters of interest of a structure on an object, the metrology tool comprising: a module for at least partially defining an aperture which is positionable so as to receive a radiation beam and to transmit a modified radiation beam; projection optics arranged to project modified radiation output by the module onto a beam spot region in which the structure is positionable; detection optics arranged to receive at least a portion of radiation scattered by the structure; and a detector operable to determine one or more parameters from the received scattered radiation; wherein the module is configured such that a size and/or shape of the aperture defined by the module is dependent on a wavelength of the received radiation.

The radiation beam may be received from a radiation source. In the plane of the module the radiation beam may be generally circular. The modified radiation beam may be modified by blocking radiation in some portions in a plane of the module. The modified radiation beam may be modified by transmission characteristics of some portions in a plane of the module.

The advantages of the metrology tool according to the first aspect are now discussed.

The metrology tool may, for example, comprise a scatterometer for use in measuring targets on an object (for example a lithographic wafer). For example, it may comprise a dark field scatterometer. The module may be referred to as an aperture plate. Within such a scatterometer a target (for example a periodic structure or grating) may be illuminated with a radiation beam. The radiation will scatter from the target forming a plurality of diffraction beams. At least a portion of scattered radiation (comprising at least some of the diffraction beams) may be collected by collection optics.

The response of measurements (for example overlay measurements) made in scatterometers is typically sensitive to the wavelength of radiation used by the scatterometer. Furthermore, it is desirable to separate out any background signal due to this wavelength dependence. For this reason, these scatterometry metrology tools often make a plurality of separate, sequential measurements of each metrology mark or target with different wavelengths of radiation, which are then combined. The specific wavelengths (and bandwidths) are typically dependent on the specific lithographic process or recipe and are typically optimized for a given process so as to maximize the response to overlay errors.

Furthermore, for a given target, it may be desirable to use illumination having different apertures for different wavelengths. In existing metrology tools a plurality of different aperture plates may be provided, each one suitable for use with a different combination of target pitch and wavelength. In order to define different apertures, when a new wavelength is selected, the aperture plate may be swapped for another aperture plate (for example a plurality of aperture plates may be provided on a wheel such that each may be placed in the beam path, one at a time). However, it has been found that this results in a loss of throughput as it takes a non-zero amount of time to swap the aperture plates. An alternative may be to use the same aperture for all wavelengths, however, this means that a sub-optimal aperture will be used for at least some wavelengths, again resulting in a loss of throughput.

Advantageously, the metrology tool according to the first aspect allows for different apertures to be selected when different illumination wavelengths are used. That is, once the illuminating wavelength has been selected an appropriate aperture is automatically selected by virtue of the transmission characteristics of the module.

The module may be positionable in a pupil plane of the metrology tool.

It will be appreciated that the pupil plane of the metrology tool is intended to mean a plane that is a Fourier transform plane of the beam spot region or field plane. That is, the intensity distribution of the radiation in the beam spot region is a Fourier transform of the intensity distribution of the radiation in the pupil plane. It will be appreciated that all rays from any given point in the pupil plane are mapped onto substantially the entire beam spot region. Put differently, the rays from any given point in the pupil plane illuminate the entire field of view (FOV) of the metrology tool. Similarly, a single point in the beam spot region maps onto substantially the entire pupil plane. The intensity distribution of the radiation in a pupil plane characterizes the angular distribution of radiation in a field plane (i.e. the beam spot region). In some embodiments, module may be disposed in a plane that is close to a pupil plane of the metrology tool (and may be referred to as a "pupil-like plane").

The metrology tool may further comprise a beam-modifying module arranged to control one or more properties of the radiation beam. In some embodiments, the beam-modifying module may be arranged to control a spectrum of the radiation beam. Additionally or alternatively, in some embodiments, the beam-modifying module may comprise beam shaping optics such as, for example, a collimator and/or an aperture stop.

That is, the beam-modifying module is optically upstream of the module and is arranged to control one or more properties of (such as, for example, a spectrum of) the radiation beam before it is received by the module. As used here, control of the spectrum of a radiation beam may include control of a central wavelength, a bandwidth and/or a shape of the spectrum of the radiation beam. For example, the beam-modifying module may comprise a colour wheel or the like. It will be appreciated that other embodiments of the beam-modifying module may comprise other apparatus for controlling the spectrum of the radiation such as, for example, an acoustic optical tunable filter or similar apparatus.

The module may be configured such that at least two different apertures can defined by the module, the aperture that is defined being dependent on the wavelength of the received radiation.

For example, illuminating the module with a radiation beam having a first wavelength (for example from a first range of wavelengths) may result in a first aperture whereas illuminating the module with a radiation beam having a second wavelength (for example from a second range of wavelengths) may result in a second aperture and so on.

It will be appreciated that the module may be configured such that any number of different apertures can defined by the module. In general, the module may be configured such that a number of different apertures that can defined by the module is equal to (or greater than) a number of different wavelengths that, in use, will be used with each target.

As explained above, scatterometry metrology tools may be used to make a plurality of separate, sequential measurements of each metrology mark or target with different wavelengths of radiation, which are then combined. In principle, the larger the number of different wavelengths the better the accuracy of the measurement, however, the slower the measurement of the target is. Therefore there is a balance to be struck. In practice, each mark may be measured with two, three or four different wavelengths.

The module may be configured such that a finite number of different apertures can defined by the module.

For example, the different apertures may each be at least partially defined by a number of discrete steps in a minimum wavelength that is transmitted by the module in one or more directions.

Alternatively, the module may be configured such that a continuum of different apertures can defined by the module. For example, the different apertures may each be at least partially defined a gradient in a minimum wavelength that is transmitted by the module in one or more directions.

The module may be configured such that at least two different apertures that can be defined by the module at least partially overlap.

For example, in some embodiments one of the (smaller) apertures may completely overlap with another one of the (larger apertures). That is, the smaller aperture may comprise a first region of the module and the larger aperture may comprise the first region plus an additional, second region of the module.

In some embodiments, the module is configured such that a plurality of different nested apertures can be defined. In some embodiments, the module is configured such that a plurality of different apertures can be defined, comprising (in ascending order) a first aperture, a second aperture and so on and wherein each aperture from the second aperture onwards comprises the same region of the module as the next smallest aperture plus an additional region.

The module may be configured such that a size of the aperture defined by the module increases with increasing wavelength.

This is advantageous since, as discussed below, in some metrology tools it is generally desirable to use a larger (smaller) aperture with larger (smaller) wavelengths.

The module may comprise a generally planar body.

It will be appreciated that a generally planar body is intended to mean a body having two larger dimensions and one smaller dimension. The two larger dimensions may define a plane of the body. The first and second portions may be portions of the plane of the body.

The module may comprise a first portion that is generally opaque.

This is advantageous when the module is disposed in a first (illumination) pupil plane of the metrology tool and it is desirable to be able to separate one or more higher order diffraction beams from the zeroth order diffraction beam in a second (measurement) pupil plane of the metrology tool (that is optically downstream of the target). Since the first portion is generally opaque, there will be corresponding portions of the second pupil plane that are not illuminated by the zeroth order diffraction beam.

It will be appreciated that the first portion being generally opaque may be intended to mean that it does not transmit a range of radiation wavelengths that are used, in use, in a metrology tool.

The module may further comprise a second portion, the second portion being adjacent the first portion and offset from the first portion in a first direction. A transmissivity of the second portion in the first direction may be dependent on wavelength such that for at least a part of the second portion a minimum wavelength that is transmitted by the second portion increases with distance from the first portion in the first direction.

Advantageously, with such an arrangement smaller wavelengths will only be transmitted by the second portion for a small range in the first direction (i.e. will have a smaller aperture) whereas larger wavelengths will be transmitted by the second portion for a larger range in the first direction (i.e. will have a larger aperture). Therefore, as explained further below, if the first direction is aligned with the dual (Fourier transformed) direction to the shearing direction of the target then the transmissivity properties of the second portion will mean that an appropriate aperture can be provided so as to avoid overlap between the zeroth and first order beams for a range of illumination radiation wavelengths. As used herein a dual direction of a first direction is intended to mean the direction in dual space (also sometimes referred to as Fourier space) that the first direction is mapped onto by a Fourier transform. For example, in a field plane (for example the plane of a marker on a wafer) a position may be specified by two directions, which may be referred to as the x-direction and the y-direction. In a pupil plane (for example in the plane in which the module may be disposed) a position may be specified by two directions, which may be referred to as the kₓ-direction and the k_{y}-direction. The kₓ-direction is the dual (Fourier transformed) direction to the x-direction and the k_{y}-direction is the dual (Fourier transformed) direction to the y-direction.

The module may further comprise a third portion, the third portion being adjacent the first portion and offset from the first portion in a second direction. A transmissivity of the third portion in the second direction may be dependent on wavelength such that for at least a part of the third portion a minimum wavelength that is transmitted by the third portion increases with distance from the first portion in the second direction.

Advantageously, this may allow the module to measure overlay in two directions (the first direction and the second direction) simultaneously. The second direction may be generally perpendicular to the first direction.

The module may further comprise a fourth portion that is generally opaque.

The fourth portion may be adj acent to the second portion and offset from the second portion in the second direction. A transmissivity of the second portion in the second direction may be dependent on wavelength such that for at least a part of the second portion a minimum wavelength that is transmitted by the second portion increases with distance from the fourth portion in the second direction.

The fourth portion may be adjacent to the third portion and offset from the third portion in the first direction. A transmissivity of the third portion in the first direction may be dependent on wavelength such that for at least a part of the third portion a minimum wavelength that is transmitted by the third portion increases with distance from the fourth portion in the first direction

The module may comprise a plurality of adjacent filters provided as separate layers and stacked in a direction of an optical axis of the metrology tool. The filters may each comprise a pass filter that transmits radiation with a wavelength above a threshold value and which blocks radiation with a wavelength below the threshold value. Each of the plurality of filters may have a different threshold value. The filters may partially overlap in a plane that is generally perpendicular to the optical axis of the metrology tool.

Alternatively, the module may comprise a plurality of filters arranged substantially in the same plane in a direction generally perpendicular to an optical axis of the metrology tool. The plurality of filters may be provided on a common support layer. The filters may each comprise a pass filter that transmits radiation with a wavelength above a threshold value and which blocks radiation with a wavelength below the threshold value. Each of the plurality of filters may have a different threshold value.

The metrology tool may comprise a plurality of modules module for at least partially defining an aperture, which are positionable so as to receive a radiation beam and to transmit a modified radiation beam and wherein each of the plurality of modules is configured such that a size and/or shape of the aperture defined by the module is dependent on a wavelength of the received radiation.

For example, the metrology tool may comprise a plurality of such modules provided on a common support (for example a wheel). By moving the support (for example rotating the wheel) one of the plurality of modules may be positionable in a path of the radiation beam. Advantageously, such an arrangement may allow for the provision of a plurality of (automatically selecting) apertures to be provided for a range of different pitches of target.

The plurality of modules may, for example, each define a different set of apertures. Additionally or alternatively, a dependence of the size and/or shape of the aperture defined by the module on the wavelength of the received radiation may be different for different modules.

The metrology tool may further comprise a radiation source operable to produce the radiation beam that is received by the module.

The radiation source may be a broadband radiation source. For example, the radiation source may be operable to produce radiation with a spectrum of around 400-900 nm. In some embodiments, the radiation source may be operable to produce radiation with a spectrum of around 400-1600 nm.

The metrology tool may further comprise a support for supporting an object such that it is positionable so as to receive the modified radiation from the module.

The support for supporting an object may comprise a substrate holder operable to secure a substrate. For example, the support may comprise a clamp for clamping the substrate to the support. The support may comprise a stage such as a wafer stage.

The metrology tool may further comprise a movement mechanism operable to cause relative movement of the support and the modified radiation beam.

This may allow the object or substrate to be stepped or scanned through the radiation. As used herein scanning of an object is intended to mean continuous movement of the object. As used herein stepping of an object is intended to mean movement of the object in a plurality of successive (temporally separated) steps.

According to a second aspect of the present disclosure there is provided a module for use in the metrology tool of the first aspect of the present disclosure.

According to a third aspect of the present disclosure there is provided a module for at least partially defining an aperture in a metrology tool wherein the module is configured such that a size and/or shape of the aperture defined by the module is dependent on a wavelength of the received radiation.

Such a module for a metrology tool is advantageous as it allows for different apertures to be automatically selected when illuminated with different wavelengths of radiation. That is, once an illuminating wavelength has been selected an appropriate aperture is automatically selected by virtue of the transmission characteristics of the module.

The module may be configured such that at least two different apertures can defined by the module, the aperture that is defined being dependent on the wavelength of the received radiation.

It will be appreciated that the module may be configured such that any number of different apertures can defined by the module. In general, the module may be configured such that a number of different apertures that can defined by the module is equal to (or greater than) a number of different wavelengths that, in use, will be used with each target within a metrology tool that the module is used in.

The module may be configured such that a finite number of different apertures can defined by the module.

For example, the different apertures may each be at least partially defined by a number of discrete steps in a minimum wavelength that is transmitted by the module in one or more directions.

Alternatively, the module may be configured such that a continuum of different apertures can defined by the module. For example, the different apertures may each be at least partially defined a gradient in a minimum wavelength that is transmitted by the module in one or more directions.

The module may be configured such that at least two different apertures that can be defined by the module at least partially overlap.

For example, in some embodiments one of the (smaller) apertures may completely overlap with another one of the (larger apertures). That is, the smaller aperture may comprise a first region of the module and the larger aperture may comprise the first region plus an additional, second region of the module.

In some embodiments, the module is configured such that a plurality of different nested apertures can be defined. In some embodiments, the module is configured such that a plurality of different apertures can be defined, comprising (in ascending order) a first aperture, a second aperture and so on and wherein each aperture from the second aperture onwards comprises the same region of the module as the next smallest aperture plus an additional region.

The module may be configured such that a size of the aperture defined by the module increases with increasing wavelength.

This is advantageous since, as discussed below, in some metrology tools it is generally desirable to use a larger (smaller) aperture with larger (smaller) wavelengths.

The module may comprise a generally planar body.

It will be appreciated that a generally planar body is intended to mean a body having two larger dimensions and one smaller dimension. The two larger dimensions may define a plane of the body. The first and second portions may be portions of the plane of the body.

The module may comprise a first portion that is generally opaque.

This is advantageous when the module is disposed in a first (illumination) pupil plane of a metrology tool and it is desirable to be able to separate one or more higher order diffraction beams from the zeroth order diffraction beam in a second (measurement) pupil plane of the metrology tool (that is optically downstream of the target). Since the first portion is generally opaque, there will be corresponding portions of the second pupil plane that are not illuminated by the zeroth order diffraction beam.

It will be appreciated that the first portion being generally opaque may be intended to mean that it does not transmit a range of radiation wavelengths that are used, in use, in a metrology tool.

The module may further comprise a second portion, the second portion being adjacent the first portion and offset from the first portion in a first direction. A transmissivity of the second portion in the first direction may be dependent on wavelength such that for at least a part of the second portion a minimum wavelength that is transmitted by the second portion increases with distance from the first portion in the first direction.

Advantageously, with such an arrangement smaller wavelengths will only be transmitted by the second portion for a small range in the first direction (i.e. will have a smaller aperture) whereas larger wavelengths will be transmitted by the second portion for a larger range in the first direction (i.e. will have a larger aperture). Therefore, as explained further below, if the first direction is aligned with the dual (Fourier transformed) direction to the shearing direction of the target then the transmissivity properties of the second portion will mean that an appropriate aperture can be provided so as to avoid overlap between the zeroth and first order beams for a range of illumination radiation wavelengths.

The module may further comprise a third portion, the third portion being adjacent the first portion and offset from the first portion in a second direction. A transmissivity of the third portion in the second direction may be dependent on wavelength such that for at least a part of the third portion a minimum wavelength that is transmitted by the third portion increases with distance from the first portion in the second direction.

Advantageously, this may allow the module to measure overlay in two directions (the first direction and the second direction) simultaneously. The second direction may be generally perpendicular to the first direction.

The module may further comprise a fourth portion that is generally opaque.

The fourth portion may be adj acent to the second portion and offset from the second portion in the second direction. A transmissivity of the second portion in the second direction may be dependent on wavelength such that for at least a part of the second portion a minimum wavelength that is transmitted by the second portion increases with distance from the fourth portion in the second direction.

The fourth portion may be adjacent to the third portion and offset from the third portion in the first direction. A transmissivity of the third portion in the first direction may be dependent on wavelength such that for at least a part of the third portion a minimum wavelength that is transmitted by the third portion increases with distance from the fourth portion in the first direction.

The module may comprise a plurality of adjacent filters provided as separate layers and stacked in a direction generally perpendicular to a plane of the module. The filters may each comprise a pass filter that transmits radiation with a wavelength above a threshold value and which blocks radiation with a wavelength below the threshold value. Each of the plurality of filters may have a different threshold value. The filters may partially overlap in a plane of the module.

Alternatively, the module may comprise a plurality of filters arranged substantially in the same plane. The plurality of filters may be provided on a common support layer. The filters may each comprise a pass filter that transmits radiation with a wavelength above a threshold value and which blocks radiation with a wavelength below the threshold value. Each of the plurality of filters may have a different threshold value.

According to a fourth aspect of the present disclosure there is provided a module for at least partially defining an aperture in a metrology tool, the module comprising: a first portion; and a second portion, the second portion being adjacent the first portion and offset from the first portion in a first direction; wherein the first portion is generally opaque; wherein a transmissivity of the second portion in the first direction is dependent on wavelength such that for at least a part of the second portion a minimum wavelength that is transmitted by the second portion increases with distance from the first portion in the first direction.

The module according to the fourth aspect is advantageous as now discussed.

In use, the module may be used in a metrology tool. Such a metrology tool may, for example, comprise a scatterometer for use in measuring targets on an object (for example a lithographic wafer). For example, it may comprise a dark field scatterometer. The module may be used for defining a shape and extent of a radiation beam in an illumination pupil plane of the metrology tool. That is, the module may be provided optically upstream of the object under investigation and in a Fourier transform plane to that of the object (the plane of the object may be referred to as a field plane). The module may be referred to as an aperture plate.

It will be appreciated that the pupil plane of the metrology tool is intended to mean a plane that is a Fourier transform plane of a beam spot region or field plane of the metrology tool. That is, the intensity distribution of the radiation in the beam spot region is a Fourier transform of the intensity distribution of the radiation in the illumination pupil plane. It will be appreciated that all rays from any given point in the pupil plane are mapped onto substantially the entire beam spot region. Put differently, the rays from any given point in the pupil plane illuminate the entire field of view (FOV) of the metrology tool. Similarly, a single point in the beam spot region maps onto substantially the entire pupil plane. The intensity distribution of the radiation in a pupil plane characterizes the angular distribution of radiation in a field plane (i.e. the beam spot region).

Within such a scatterometer a target (for example a periodic structure or grating) may be illuminated with a radiation beam. The radiation will scatter from the target forming a plurality of diffraction beams. At least a portion of scattered radiation (comprising at least some of the diffraction beams) may be collected by collection optics. As described above, the metrology tool according to the fourth aspect may be used in an illumination pupil of the tool so as to define an aperture or illumination mode of the tool used to illuminate the target. In a second pupil plane that is optically downstream of the target and conjugate to the plane of the module, there will be a contribution from a zeroth order diffraction beam, which will illuminate a portion of the second pupil plane that is optically conjugate to the second portion of the pupil. The zeroth order diffraction beam will generally not illuminate a portion of the second pupil plane that is optically conjugate to the first portion of the module.

In addition to the contribution to the second pupil plane from the zeroth order diffraction beam there will, in general, also be a contribution from each of the higher order diffraction beams (or at least each of the higher order diffraction beams that is accepted by the numerical aperture of the collection optics). The contribution to the second pupil plane from a higher order diffraction beam will in general be a copy of the contribution from the zeroth order diffraction beam which has been (a) shifted in a shearing direction of the target; and (b) weighted by a diffraction efficiency for that diffraction order of that target. Such diffraction efficiencies are, in general, dependent on the topology of the target, in particular the shape of the unit cell.

An amount by which the contribution to the second pupil plane from a higher order diffraction beam is shifted relative to the contribution from the zeroth order diffraction beam is dependent on a pitch of the target and the wavelength of the illumination radiation. For example, for a target with pitch p and illumination radiation with a wavelength λ, the angular separation between the zeroth order diffraction beam and the first order diffraction beams is sin⁻¹(λ/p). Therefore, for a fixed pitch p, the larger the wavelength the larger the angular separation Δθ between the zeroth and first order diffraction beams.

It may be desirable within a metrology tool to be able to separate the higher order diffraction beams from the zeroth order diffraction beam. This can be achieved by suitable selection optics disposed in or near the second pupil plane as long as the higher order diffraction beams do not overlap with the zeroth order diffraction beams in the second pupil plane. Therefore, it may be desirable for there to be sufficient separation between the higher order diffraction beams from the zeroth order diffraction beam in the second pupil plane such that the higher order diffraction beams overlap with a portion of the second pupil plane that is optically conjugate to the first portion of the module.

The response of measurements (for example overlay measurements) made in scatterometers is typically sensitive to the wavelength of radiation used by the scatterometer. Furthermore, it is desirable to separate out any background signal due to this wavelength dependence. For this reason, these scatterometry metrology tools often make a plurality of separate, sequential measurements of each metrology mark or target with different wavelengths of radiation, which are then combined. The specific wavelengths (and bandwidths) are typically dependent on the specific lithographic process or recipe and are typically optimized for a given process so as to maximize the response to overlay errors.

In existing metrology tools a plurality of different aperture plates may be provided, each one suitable for use with a different combination of target pitch and wavelength. For a given target, the pitch is fixed and therefore when different wavelengths are used for measurements the shift of the first order diffraction beams (relative to the zeroth order beams) in the second pupil plane will vary. As a result, with existing arrangements, in order to avoid overlap between the zeroth and first order beams either (a) the same aperture plate (i.e. the same pupil) is used for all wavelengths, the aperture being sufficiently small so as to avoid overlap between the zeroth and first order beams; or (b) the aperture plate may be swapped for another aperture plate (for example a plurality of aperture plates may be provided on a wheel such that each may be placed in the beam path, one at a time). Disadvantageously, solution (a) means that a than optimal smaller aperture is used for some wavelengths and this results in a loss of throughput. Similarly, solution (b) results in a loss of throughput as it takes a non-zero amount of time to swap the aperture plates.

Advantageously, the module according to the fourth aspect comprises a second portion having a transmissivity in the first direction that is dependent on wavelength such that for at least a part of the second portion a minimum wavelength that is transmitted by the second portion increases with distance from the first portion in the first direction. Therefore, smaller wavelengths will only be transmitted by the second portion for a small range in the first direction (i.e. will have a smaller aperture) whereas larger wavelengths will be transmitted by the second portion for a larger range in the first direction (i.e. will have a larger aperture). Therefore, if the first direction is aligned with the dual (Fourier transformed) direction to the shearing direction of the target then the transmissivity properties of the second portion will mean that an appropriate aperture can be provided so as to avoid overlap between the zeroth and first order beams for a range of illumination radiation wavelengths.

It will be appreciated that the first portion being generally opaque may be intended to mean that it does not transmit a range of radiation wavelengths that are used, in use, in a metrology tool.

The module may further comprise a third portion, the third portion being adjacent the first portion and offset from the first portion in a second direction. A transmissivity of the third portion in the second direction may be dependent on wavelength such that for at least a part of the third portion a minimum wavelength that is transmitted by the third portion increases with distance from the first portion in the second direction.

Advantageously, this may allow the module to measure overlay in two directions (the first direction and the second direction) simultaneously. The second direction may be generally perpendicular to the first direction.

The module may further comprise a fourth portion that is generally opaque.

The fourth portion may be adj acent to the second portion and offset from the second portion in the second direction. A transmissivity of the second portion in the second direction may be dependent on wavelength such that for at least a part of the second portion a minimum wavelength that is transmitted by the second portion increases with distance from the fourth portion in the second direction.

The fourth portion may be adjacent to the third portion and offset from the third portion in the first direction. A transmissivity of the third portion in the first direction may be dependent on wavelength such that for at least a part of the third portion a minimum wavelength that is transmitted by the third portion increases with distance from the fourth portion in the first direction.

The module may comprise a generally planar body. It will be appreciated that a generally planar body is intended to mean a body having two larger dimensions and one smaller dimension. The two larger dimensions may define a plane of the body. The first, second, third and fourth portions may be portions of the plane of the body.

Alternatively, in some embodiments the module may comprise a plurality of bodies. In use, each such body may be disposed in a different plane, all of the planes being optically conjugate (for example the planes may all be pupil planes of a metrology tool). For example, the first portion may be defined on a first body and the second portion may be defined on a second body.

In an example we disclose a module for at least partially defining an aperture in a metrology tool on an optical path between a light input and a light output, the module comprising: the light input for receiving an incoming light beam; the light output for outputting a shaped light beam; a first transmissive region being configured to transmit light in a first spectral range; a second transmissive region being configured to transmit light in a second spectral range, wherein the first spectral range and the second spectral range are selected such that, if light of a first wavelength band of the incoming light beam is received by the light input, a first effective aperture is formed to provide the shaped light beam, and if light of a second wavelength band of the incoming light beam is received by the light input, a second effective aperture is formed to provide the shaped light beam.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a metrology apparatus, such as a scatterometer, comprising a radiation projector and a spectrometer detector;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts an alignment sensor;
- Figure 7 depicts a schematic representation of a known type of colour selection module;
- Figure 8 schematically shows a new metrology tool for determining one or more parameters of interest of a structure on an object (such as, for example, a wafer) according to an embodiment of the present disclosure;
- Figure 9 schematically shows the layout of an embodiment of the module (in a plane of the module) for at least partially defining an aperture within the metrology tool of Figure 8;
- Figure 10A shows a transmission spectrum of the first regions of the embodiment shown in Figure 9;
- Figure 10B shows a transmission spectrum of the second regions of the embodiment shown in Figure 9;
- Figure 10C shows a transmission spectrum of the third regions of the embodiment shown in Figure 9;
- Figure 10D shows a transmission spectrum of the fourth regions of the embodiment shown in Figure 9;
- Figure 11A shows a first aperture that can be defined using the embodiment shown in Figure 9;
- Figure 11B shows a second aperture that can be defined using the embodiment shown in Figure 9;
- Figure 11C shows a third aperture that can be defined using the embodiment shown in Figure 9; and
- Figure 11D shows a fourth aperture that can be defined using the embodiment shown in Figure 9.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

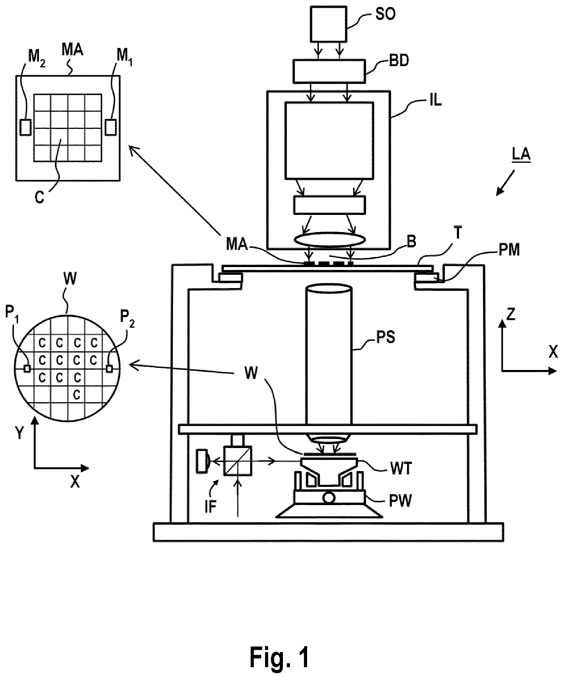

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

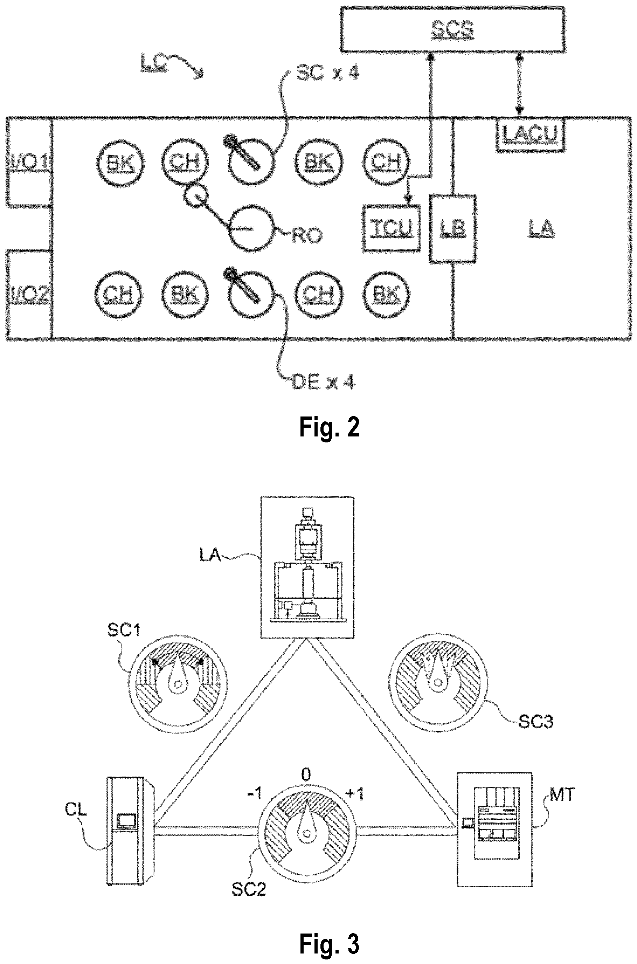

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

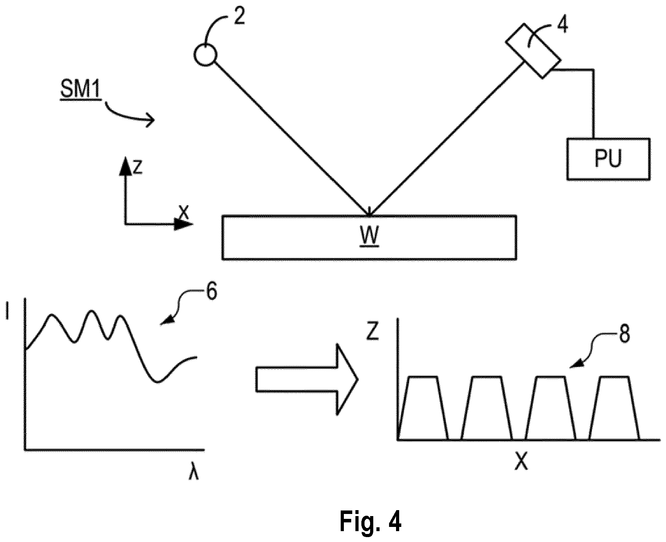

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

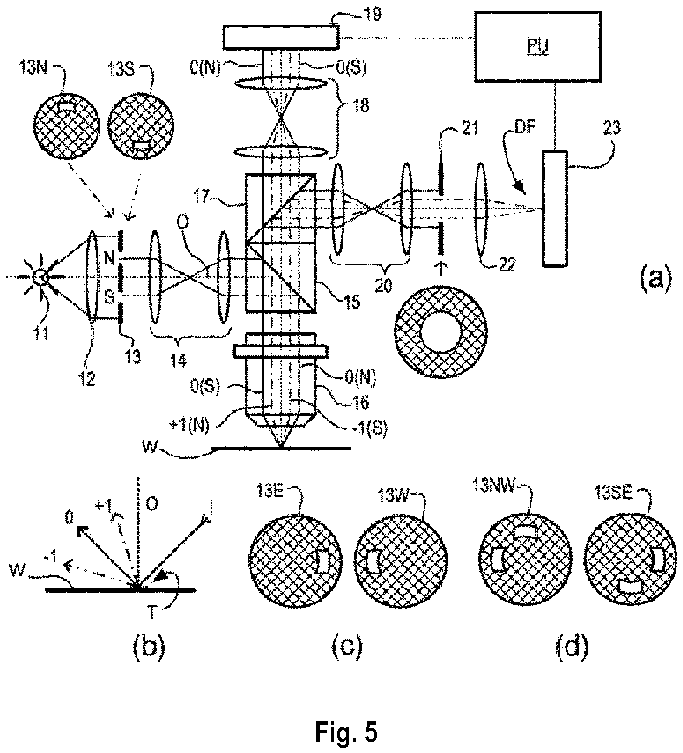

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

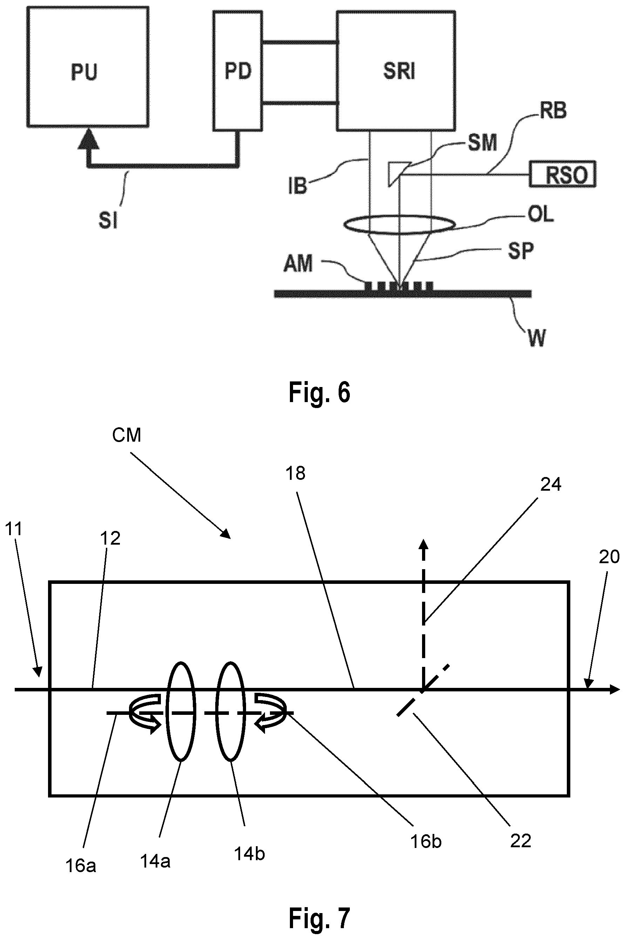

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology and/or inspection tools (also referred to as measurement tools) such as the ones described above often use radiation to obtain measurement data. Depending on the measurement target and the properties to be measured, different types of radiation may be used. One differing property of radiation is the wavelength(s) used to obtain a measurement, as different wavelengths may provide different information about a measurement target. Some measurement tools may use broadband radiation, such as supercontinuum radiation, either to measure using broadband radiation, or to be able to tune and select the measurement wavelength(s) to be used. Depending on the range of output wavelengths and properties of the broadband source, difference methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects.

In order to provide a radiation source that is able to switch between desired wavelengths, the radiation source may include a colour selection module. A known example of such a colour selection module CM is depicted schematically in Figure 7. The colour selection module CM is provided with an input 11 for a beam of broadband radiation 12. The beam of radiation 12 passes through a pair of rotatable colour wheels 14a, 14b. The colour wheels 14a, 14b may each be considered to be multilayer (spectral) filters. That is to say, each colour wheel has a multilayer structure - each layer being formed from different materials each having a different transmission spectrum. The overall transmission spectrum of a particular portion of each colour wheel depends upon the thickness and material of each layer of the multilayer structure at said portion. One or more properties of the multilayer structure (e.g. thickness of each of the layers of the multilayer structure) is varied as a function of angular location around the wheel. As such, the overall transmission spectrum of each colour wheel varies as a function of angular location around the wheel. Each of the wheels 14a, 14b can be rotated about a respective rotation axis 16a, 16b. It follows that the overall transmission spectrum of each of the colour wheels 14a, 14b varies with angular orientation about the rotation axis 16a, 16b. By rotating each of the colour wheels 14a, 14b about their respective axis 16a, 16b and controlling the angular position of each of the colour wheels 14a, 14b, a portion of each of the colour wheels 14a, 14b through which the broadband radiation beam 12 passes can be controlled. This provides control over the overall transmission spectrum of the multilayer structure of said portion of each colour wheel 14a, 14b through which the radiation beam 12 passes. Therefore, this provides control over properties of a narrowband beam of radiation 18 which is output from the colour wheels 14a, 14b. For example, one of the colour wheels 14a may function as a low pass filter and the other of the colour wheels 14b may function as a high pass filter. By controlling the angular position of each of the colour wheels 14a, 14b, about their respective axis 16a, 16b the cut off frequency provided by the low pass filter of one of the colour wheels and the high pass filter of the other of the colour wheels can be varied. In this way, it is possible to control both a central wavelength and a spectral bandwidth of the narrowband radiation 18 which is output from the colour wheels 14a, 14b. The narrowband radiation 18 exits at an output 20 of the colour selection module CM.

The colour selection module CM may also include a reflector 22 which creates a secondary beam path 24. A portion of the radiation 18 that is directed along this secondary beam path 24 can be used to measure properties of the narrowband radiation 18 as the colour selection module CM is operating, which may be used to calibrate the colour selection module CM. For example, the portion of the radiation 18 that is directed along this secondary beam path 24 may be used to ensure that when the colour wheels 14a, 14b are in particular positions a desired central wavelength and spectral bandwidth of narrowband radiation 18 is output by the colour selection module CM.

The colour wheels 14a, 14b may be relatively large (as their size may be, in part, dictated by the properties of the multilayer structures which form part of each of the colour wheels and which may need to be of particular size to enable a desired degree of spatial resolution depending on the angular position of the colour wheels). A switching speed of the colour selection module CM may be dependent on: (a) the masses of the colour wheels 14a, 14b; and (b) the typical distances by which each of the colour wheels are moved so as to change the central wavelength and spectral bandwidth of the narrowband radiation 18 output by the colour selection module CM. As used herein a switching speed of the colour selection module CM is intended to mean a time taken to switch between (i) a first desired central wavelength and spectral bandwidth of narrowband radiation 18 and (ii) a second desired central wavelength and spectral bandwidth of narrowband radiation 18.

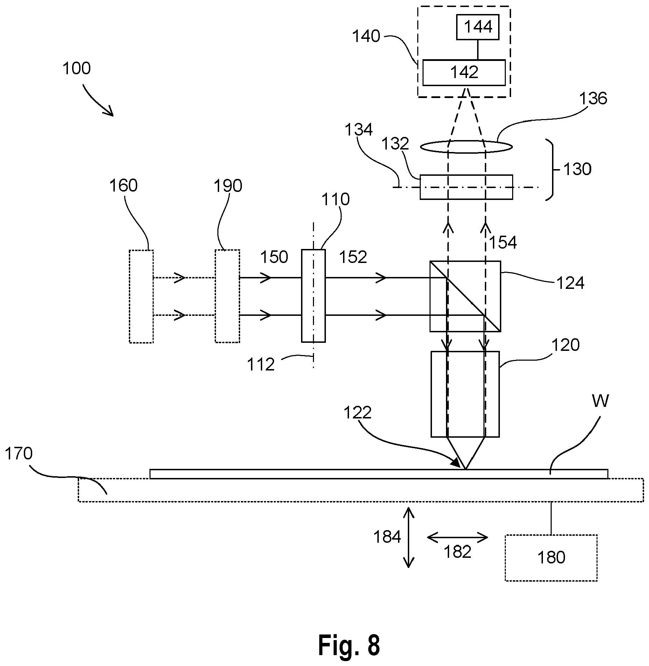

Some embodiments of the present disclosure relate to a new metrology tool for determining one or more parameters of interest of a structure on an object (such as, for example, a wafer W). An example of such a new metrology tool 100 is shown schematically in Figure 8 and now described.

The metrology tool 100 comprises: a module 110 for at least partially defining an aperture; projection optics 120; detection optics 130; and a detector 140. In some embodiments, the metrology tool 100 may, for example, be generally of the form of the dark field scatterometer shown in Figure 5(a).

The module 110 for at least partially defining an aperture is positionable so as to receive a radiation beam 150 and to transmit a modified radiation beam 152. The module will be described in further detail below. In some embodiments, the module 110 may be placed instead of the aperture plate 13 shown in Figure 5(a).

The projection optics 120 is arranged to project the modified radiation 152 output by the module 110 onto a beam spot region 122 in which a structure (for example a target on a wafer W) is positionable. In some embodiments, the projection optics 120 may be placed instead of the objective lens 16 shown in Figure 5(a). In this embodiment, a beam splitter 124 is provided to direct a portion of the modified radiation 152 output by the module 110 to the projection optics 120.

The detection optics 130 is arranged to receive at least a portion of radiation 154 scattered by the structure. In some embodiments, the detection optics 130 may be placed instead of the optics disposed between the wafer W and the sensor 23 shown in Figure 5(a). In particular, the detection optics 130 may comprise one or more components that are similar to the aperture stop 21 shown in Figure 5(a). In particular, in some embodiments, the detection optics 130 comprises a component 132 that is disposed in a measurement pupil plane 134. The component 132 that is disposed in a measurement pupil plane 134 may be similar to the aperture stop 21 shown in Figure 5(a).

As used herein the detector 140 is intended to mean both a sensor 142 (for example a sensor array or camera) and a processor 144.

The detection optics 130 may comprise optics 136 arranged to form an image of the beam spot region 122 on the sensor 142 of the detector 140. That is, the sensor 142 of the detector 140 may be disposed in a conjugate plane to the beam spot region 122. As discussed above, it is desirable that the zeroth order diffraction beam from the target does not contribute to the "image" formed by the optics 136. Therefore, as discussed above, the component 132 that is disposed in the measurement pupil plane 134 may be arranged to ensure that the zeroth order radiation from the target does not contribute to the image formed on the sensor 142 of the detector 140. For example, the zeroth order radiation may be blocked.

The detector 140 is operable to determine one or more parameters from the received scattered radiation 154. In particular, the processor 144 of the detector 140 is operable to determine one or more parameters from the received scattered radiation 154. In particular, the processor 144 of the detector 140 may be operable to determine one or more parameters (for example overlay measurements) from an image formed by the detection optics 130 on the sensor 142 of the detector 140. In some embodiments, the detector 140 may be placed instead of the sensor 23 shown in Figure 5(a). For example, the sensor 142 of the detector 140 may be placed instead of the sensor 23 shown in Figure 5(a). It will be appreciated that the invention may also be applicable to other inspection apparatuses or scatterometers as described above, for example an apparatus where the detector, or sensor, is in the pupil plane or conjugate pupil plane where the measurements are pupil based measurements.

Optionally, the metrology tool 100 may further comprise a radiation source 160 operable to produce the radiation beam 150 that is received by the module 110. The radiation source 160 may be a broadband radiation source. For example, the radiation source 160 may be operable to produce radiation with a spectrum of around 400-900 nm. In some embodiments, the radiation source 160 may be operable to produce radiation with a spectrum of around 400-1600 nm.

Optionally, the metrology tool 100 may further comprise a support 170 for supporting an object (such as a wafer W) such that the object is positionable so as to receive the modified radiation 152 from the module 110. That is, the object may be positionable such that a portion thereof is disposed in the beam spot region 122.

The support 170 for supporting an object may comprise a substrate holder operable to secure a substrate W. For example, the support 170 may comprise a clamp for clamping the substrate W to the support 170. The support may comprise a stage such as a wafer stage (for example of the form of the substrate support WT shown in Figure 1).

The metrology tool 100 may further comprise a movement mechanism 180 operable to cause relative movement of the support 170 and the modified radiation beam 152. Such relative movement is indicated schematically by arrows 182, 184. This may allow the object or substrate W to be stepped or scanned through the radiation 152. As used herein scanning of an object W is intended to mean continuous movement of the object W. As used herein stepping of an object W is intended to mean movement of the object W in a plurality of successive (temporally separated) steps.

Optionally, the metrology tool 100 may further comprise a beam-modifying module 190 that is arranged to control one or more properties of the radiation beam 150 such as, for example, a spectrum of the radiation beam 150.

That is, the beam-modifying module 190 is optically upstream of the module 110 and is arranged to control one or more properties of (such as, for example, a spectrum of) the radiation beam 150 before it is received by the module 110. As used here, control of the spectrum of a radiation beam 150 may include control of a central wavelength, a bandwidth and/or a shape of the spectrum of the radiation beam 150. For example, the beam-modifying module may comprise a colour wheel or the like. The beam-modifying module 190 may comprise a colour selection module CM of the type shown schematically in Figure 7 and described above. It will be appreciated that other embodiments of the beam-modifying module 190 may comprise other apparatus for controlling the spectrum of the radiation 150 such as, for example, an acoustic optical tunable filter or similar apparatus.

Additionally or alternatively, in some embodiments, the beam-modifying module 190 may comprise beam shaping optics such as, for example, a collimator and/or an aperture stop.

The module 110 is configured such that a size and/or shape of the aperture defined by the module is dependent on a wavelength of the received radiation 150.

The radiation beam 150 may be received (directly or indirectly) from the radiation source 160. In the plane of the module 110 the radiation beam 150 may be generally circular. As discussed further below, the modified radiation beam 152 may be modified by blocking radiation in some portions in a plane of the module 110. As discussed further below, the modified radiation beam 152 may be modified by transmission characteristics of some portions in a plane of the module 110.

The advantages of the new metrology tool 100 shown in Figure 8 are now discussed.

The metrology tool 100 may, for example, comprise a scatterometer for use in measuring targets on an object (for example a lithographic wafer W). For example, it may comprise a dark field scatterometer. The module 110 may be referred to as an aperture plate or apodizer plate. Within such a scatterometer a target (for example a periodic structure or grating) may be illuminated with a radiation beam 152. The radiation will scatter from the target forming a plurality of diffraction beams. At least a portion of scattered radiation 154 (comprising at least some of the diffraction beams) may be collected by collection optics 120.

The response of measurements (for example overlay measurements) made in scatterometers is typically sensitive to the wavelength of radiation used by the scatterometer. Furthermore, it is desirable to separate out any background signal due to this wavelength dependence. For this reason, these scatterometry metrology tools often make a plurality of separate, sequential measurements of each metrology mark or target with different wavelengths of radiation, which are then combined. The specific wavelengths (and bandwidths) are typically dependent on the specific lithographic process or recipe and are typically optimized for a given process so as to maximize the response to overlay errors.

Furthermore, for a given target, it may be desirable to use illumination having different apertures for different wavelengths. In existing metrology tools a plurality of different aperture plates may be provided, each one suitable for use with a different combination of target pitch and wavelength. In order to define different apertures, when a new wavelength is selected, the aperture plate may be swapped for another aperture plate (for example a plurality of aperture plates may be provided on a wheel such that each may be placed in the beam path, one at a time). However, it has been found that this results in a loss of throughput as it takes a non-zero amount of time to swap the aperture plates. An alternative may be to use the same aperture for all wavelengths, however, this means that a sub-optimal aperture will be used for at least some wavelengths, again resulting in a loss of throughput.

Advantageously, the metrology tool 100 shown in Figure 8 allows for different apertures to be selected when different illumination wavelengths are used. That is, once the illuminating wavelength has been selected (for example via the beam-modifying module 190) an appropriate aperture is automatically selected by virtue of the transmission characteristics of the module 110.

In some embodiments, the module 110 may be is positionable in a pupil plane 112 of the metrology tool 100.

It will be appreciated that the pupil plane of the metrology tool 100 is intended to mean a plane that is a Fourier transform plane of the beam spot region 122 or field plane. That is, the intensity distribution of the radiation in the beam spot region 122 is a Fourier transform of the intensity distribution of the radiation in the pupil plane 112. It will be appreciated that all rays from any given point in the pupil plane 112 are mapped onto substantially the entire beam spot region 122. Put differently, the rays from any given point in the pupil plane 112 illuminate the entire field of view (FOV) of the metrology tool 100. Similarly, a single point in the beam spot region 122 maps onto substantially the entire pupil plane 112. The intensity distribution of the radiation in a pupil plane 112 characterizes the angular distribution of radiation in a field plane (i.e. the beam spot region 122). In some embodiments, module 110 may be disposed in a plane that is close to a pupil plane of the metrology tool (and may be referred to as a "pupil-like plane").

In some embodiments, the metrology tool 100 comprises a plurality of modules 110. For example, the metrology tool 100 may comprise a plurality of such modules 110 provided on a common support (for example a wheel). By moving the support (for example rotating the wheel) one of the plurality of modules 110 may be positionable in a path of the radiation beam 150. Advantageously, such an arrangement may allow for the provision of a plurality of (automatically selecting) apertures to be provided for a range of different pitches of target.

The plurality of modules 110 may, for example, each define a different set of apertures. Additionally or alternatively, a dependence of the size and/or shape of the aperture defined by the module 110 on the wavelength of the received radiation may be different for different modules 110.

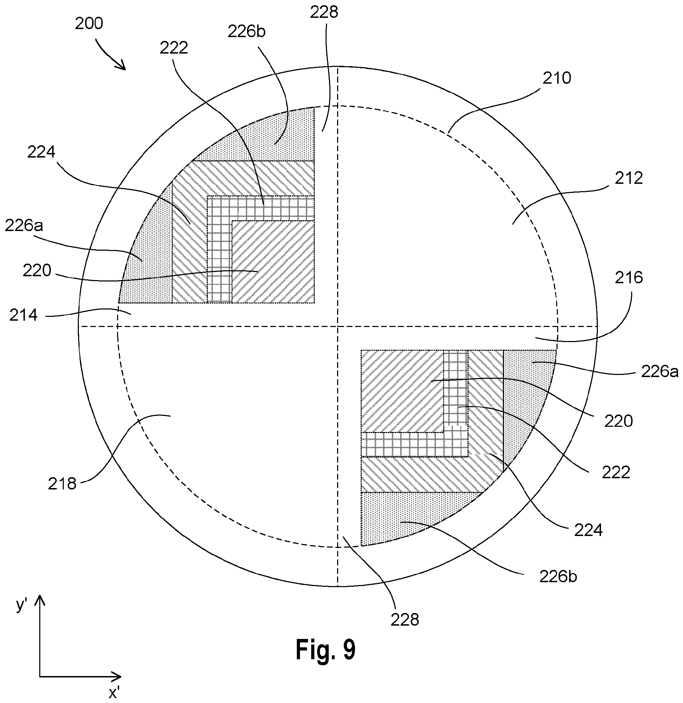

As discussed above, the module 110 for at least partially defining an aperture is configured such that a size and/or shape of the aperture defined by the module 110 is dependent on a wavelength of the received radiation 150. Embodiments of such a module 110 are now discussed with reference to Figures 9 to 11D.

In general, the module 110 may comprise a generally planar body. It will be appreciated that a generally planar body is intended to mean a body having two larger dimensions and one smaller dimension. The two larger dimensions may define a plane of the body.

Figure 9 schematically shows the layout of an embodiment 200 of the module 110 (in a plane of the module 110) for at least partially defining an aperture within the metrology tool 100 of Figure 8. It will be appreciated that, in use, the embodiment is disposed such that an optical axis of the radiation 150 is substantially perpendicular to the plane of Figure 9.

The embodiment 200 comprises a generally circular portion 210 that, in use, is concentric with an optical axis of the radiation 150 and which corresponds to a numerical aperture of the projection optics 120. This generally circular portion 210 may be considered to comprise four portions: a first portion 212, a second portion 214, a third portion 216 and a fourth portion 218. Each of the four portions 210 corresponds to a quarter of the circular portion 210. The first and fourth portions 212, 218 are mutually diametrically opposed and the second and third portions 214, 216 are mutually diametrically opposed. The first and fourth portions 212, 218 are opaque and therefore, when in use, the first and fourth portions 212, 218 block the radiation beam 150.

Each of the second and third portions 214, 216 of the embodiment 200 comprises a plurality of regions having different transmission properties. In particular, each of the second and third portions 214, 216 of the embodiment 200 comprises a first region 220, a second region 222, a third region 224 and a fourth region 226a, 226b. Except for the first regions 220, the second regions 222, the third regions 224 and the fourth regions 226a, 226b, all other regions of the embodiment 200 are generally opaque. In this embodiment, in addition to the first region 220, the second region 222, the third region 224 and the fourth region 226a, 226b, each of the second and third portions 214, 216 of the embodiment 200 comprises a generally L-shaped opaque portion 228. In other embodiments, each set of first region 220, second region 222, third region 224 and fourth region 226a, 226b may occupy substantially all of a quarter of the circular portion 210.

The first regions 220 are generally square, although it can be imagined that they can take any shape, such as for example rectangular, triangular, circular, oval, diamond, or any other shape derived or combined from these shapes.

The second regions 222 are generally L-shaped and configured such that together each first region 220 and corresponding second region 222 define a generally square region.

The third regions 224 are defined by a portion of a generally L-shaped region intersects with the circular region 210 (corresponding to the numerical aperture of the projection optics 120). In particular, the third regions 224 are defined by a portion of a generally L-shaped region that lies within the circular region 210 (corresponding to the numerical aperture of the projection optics 120). The third regions 224 are configured such that together each set of corresponding first region 220, second region and third region 224 define a generally square region that is partially truncated by the circular region 210 (corresponding to the numerical aperture of the projection optics 120).

The fourth regions 226a, 226b are defined by a portion of a generally L-shaped region intersects with the circular region 210 (corresponding to the numerical aperture of the projection optics 120). In particular, the fourth regions 226a, 226b are defined by a portion of a generally L-shaped region that lies within the circular region 210 (corresponding to the numerical aperture of the projection optics 120). In this embodiment, the fourth regions 226a, 226b comprise two separate regions. The fourth regions 226a, 226b are configured such that together each set of corresponding first region 220, second region, third region 224 and fourth region 226a, 226b define a generally square region that is partially truncated by the circular region 210 (corresponding to the numerical aperture of the projection optics 120). It can be imagined that the described regions can take any shape, such as for example rectangular, square, triangular, circular, oval, diamond, or any other shape derived or combined from these shapes.

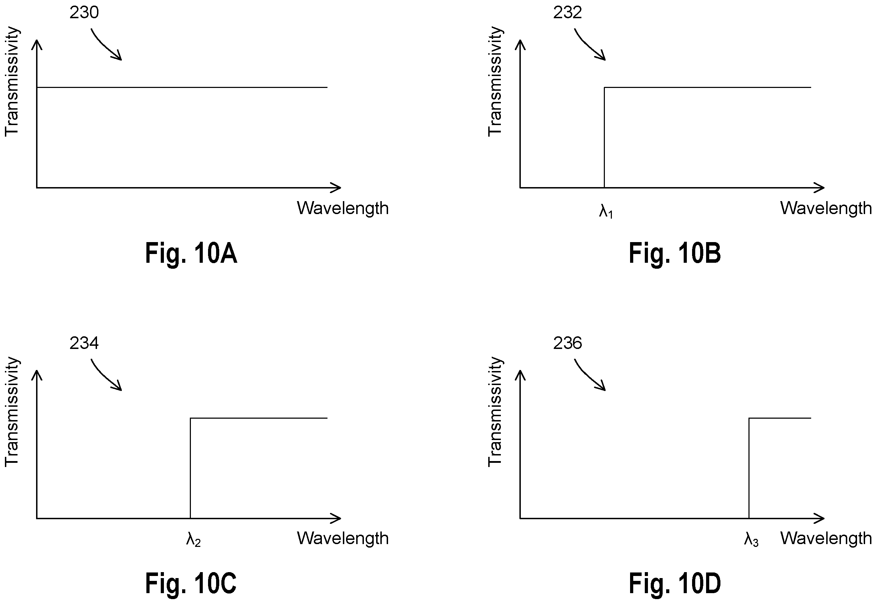

The transmission spectra 230, 232, 234, 236 of the first, second, third and fourth regions 220, 222, 224, 226a, 226b are shown in Figures 10A-10D respectively. For simplicity, the transmission spectra 230, 232, 234, 236 are shown as being generally binary (either blocking the radiation or transmitting the radiation), however please note that in a practical embodiment there could be a smooth transition. In general, where a region is described as being transmissive for a wavelength (or wavelength range) this may mean a transmissivity of 95% or greater. In some embodiments, a region being described as being transmissive for a wavelength (or wavelength range) may mean a transmissivity of 50% or greater. In some embodiments, a region being described as being transmissive for a wavelength (or wavelength range) may mean a transmissivity of 60% or greater. In some embodiments, a region being described as being transmissive for a wavelength (or wavelength range) may mean a transmissivity of 70% or greater. In some embodiments, a region being described as being transmissive for a wavelength (or wavelength range) may mean a transmissivity of 80% or greater. In some embodiments, a region being described as being transmissive for a wavelength (or wavelength range) may mean a transmissivity of 90 % or greater, preferably 95 % or greater. Furthermore, in general, where a region is described as being transmissive for a wavelength (or wavelength range), variations in the transmissivity may be less than 2% of the absolute transmissivity.

Each of the first, second, third and fourth regions 220, 222, 224, 226a, 226b comprises a pass filter that transmits radiation with a wavelength above a threshold value and which blocks radiation with a wavelength below the threshold value. Alternatively the pass filter may transmit radiation with a wavelength below a threshold value and block radiation with a wavelength above the threshold value. The pass filter may also have multiple threshold values, where above a first threshold value radiation is transmitted and below this first threshold radiation is blocked, and where above a second threshold value radiation is blocked and below this second threshold radiation is transmitted, eventually acting as a band pass filter. Each of the plurality of filters may have a different threshold value. The first regions 220 may transmit substantially all wavelengths (i.e. may not have a non-zero threshold value). For example, the first regions 220 may be generally transmissive for substantially all wavelengths (for example the first regions 220 may comprise an aperture). Alternatively, the first regions 220 may be generally transmissive for all wavelengths that the embodiment 200 of the module 110 will receive when in use. For example, the first regions 220 may have a threshold value that is generally equal to or less than a lower value of a spectral output of the radiation source 160 of the metrology tool 100. For example, as discussed above, the radiation source 160 may be operable to produce radiation with a spectrum of around 400-900 nm (or 400-1600 nm) and the first regions 220 may have a threshold value that is around 400 nm or below. The threshold value λ₁ for the second regions 222 is less than the threshold value λ₂ for the third regions 224. The threshold value λ₂ for the third regions 224 is less than the threshold value λ₃ for the fourth regions 226.

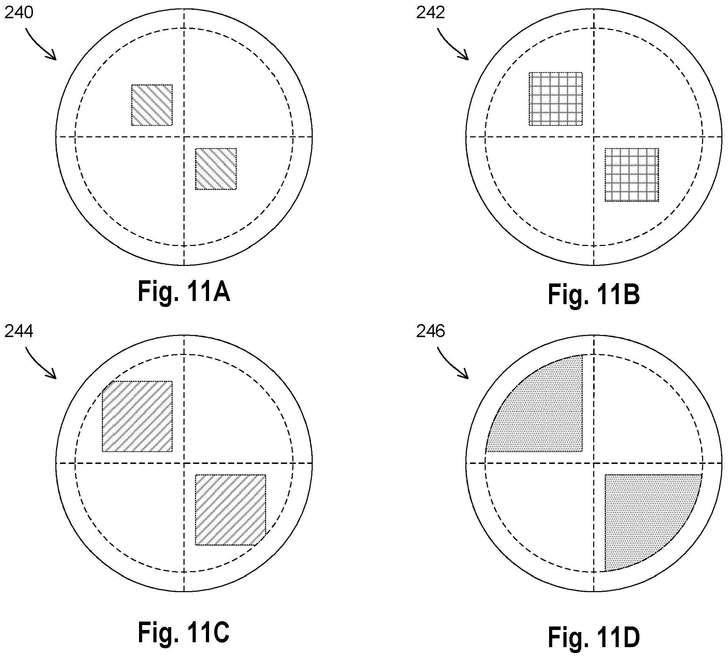

Such an arrangement 200 of the module 110 is configured such that a size and shape of the aperture defined by the module 110 is dependent on a wavelength of the received radiation 150, as now discussed with reference to Figures 11A to 11D.

When the module 110 receives radiation with a wavelength λ that is less than the threshold value λ₁ for the second regions 222, such radiation is only transmitted by the first regions 220. With such an arrangement (*λ* < *λ*₁), a first aperture 240 (see Figure 11A) is defined which comprises only the first regions 220.

When the module 110 receives radiation with a wavelength *λ* that is greater than the threshold value λ₁ for the second regions 222 and less than the threshold value λ₂ for the third regions 224, such radiation is only transmitted by the first and second regions 220, 222. With such an arrangement (*λ*₁ < *λ* < *λ*₂), a second aperture 242 (see Figure 11B) is defined which comprises the first and second regions 220, 222.

When the module 110 receives radiation with a wavelength *λ* that is greater than the threshold value λ₂ for the third regions 224 and less than the threshold value λ₃ for the fourth regions 226a, 226b, such radiation is only transmitted by the first, second and third regions 220, 222, 224. With such an arrangement (*λ*₂ < *λ* < *λ*₃), a third aperture 244 (see Figure 11C) is defined which comprises the first, second and third regions 220, 222, 224.

When the module 110 receives radiation with a wavelength λ that is greater than the threshold value λ₃ for the fourth regions 226a, 226b, such radiation is transmitted by the first, second, third and fourth regions 220, 222, 224, 226a, 226b. With such an arrangement (*λ* > *λ*₃), a fourth aperture 246 (see Figure 11D) is defined which comprises the first, second, third and fourth regions 220, 222, 224, 226a, 226b.

Therefore, the embodiment 200 shown in Figure 9 is configured such that four different apertures (see Figures 11A to 11D) can defined by the module 110, the aperture that is defined being dependent on the wavelength λ of the received radiation 150. It will be appreciated that this is merely a single example embodiment and that other embodiments may allow for a different number of different apertures to be defined. In general, the module 110 is configured such that at least two different apertures can defined by the module 110 (the aperture that is defined being dependent on the wavelength λ of the received radiation 150). For example, illuminating the module 110 with a radiation beam having a first wavelength (for example from a first range of wavelengths) may result in a first aperture whereas illuminating the module with a radiation beam having a second wavelength (for example from a second range of wavelengths) may result in a second aperture and so on.

It will be appreciated that the module 110 may be configured such that any number of different apertures can defined by the module 110. In general, the module 110 may be configured such that a number of different apertures that can defined by the module 110 is equal to (or greater than) a number of different wavelengths that, in use, will be used with each target.

As explained above, scatterometry metrology tools may be used to make a plurality of separate, sequential measurements of each metrology mark or target with different wavelengths of radiation, which are then combined. In principle, the larger the number of different wavelengths the better the accuracy of the measurement, however, the slower the measurement of the target is. Therefore, there is a balance to be struck. In practice, each mark may be measured with, for example, two, three or four different wavelengths.

The embodiment 200 shown in Figure 9 is configured such that a finite number (four) of different apertures can defined by the module 110. As explained above with reference to Figures 10A to 11D, the different apertures 240, 242, 244, 246 are each be at least partially defined by a number of discrete steps in a minimum wavelength that is transmitted by the module 110 in one or more directions.

Alternatively, in other embodiments, the module 110 may be configured such that a continuum of different apertures can defined by the module 110. For example, the different apertures may each be at least partially defined a gradient in a minimum wavelength that is transmitted by the module in one or more directions.

The embodiment 200 shown in Figure 9 is configured such that the four different apertures 240, 242, 244, 246 that can be defined by the module 110 at least partially overlap with each other. In general, the module 110 may be configured such that at least two different apertures that can be defined by the module 110 that at least partially overlap.

For example, in some embodiments one of the (smaller) apertures 240, 242, 244 may completely overlap with another one of the (larger apertures 242, 244, 246). That is, the smaller aperture (for example aperture 240) may comprise a first region (for example first regions 220) of the module 110 and the larger aperture (for example aperture 242) may comprise the first region (for example first regions 220) plus an additional, second region of the module (for example second regions 222).

In some embodiments (such as, for example, the embodiment 200 shown in Figure 9), the module 110 may be configured such that a plurality of different nested apertures 240, 242, 244, 246 can be defined. In some embodiments, the module 110 is configured such that a plurality of different apertures can be defined, comprising (in ascending order) a first aperture 240, a second aperture 242 and so on and wherein each aperture from the second aperture onward comprises the same region of the module 110 as the next smallest aperture plus an additional region.

The embodiment 200 shown in Figure 9 is configured such that a size of the aperture 240, 242, 244, 246 defined by the module 110 increases with increasing wavelength, λ, of the received radiation 150. This is advantageous since, as discussed below, in some metrology tools 100 it is generally desirable to use a larger (smaller) aperture with larger (smaller) wavelengths.

The embodiment 200 shown in Figure 9 comprises a first portion 212 that is generally opaque. This is advantageous when the module 110 is disposed in a first (illumination) pupil plane 112 of the metrology tool 100 and it is desirable to be able to separate one or more higher order diffraction beams from the zeroth order diffraction beam in a second (measurement) pupil plane 134 of the metrology tool 100 (that is optically downstream of the target). Since the first portion 212 is generally opaque, there will be corresponding portions of the second pupil plane 134 that are not illuminated by the zeroth order diffraction beam.

It will be appreciated that the first portion 212 being generally opaque may be intended to mean that it does not transmit a range of radiation wavelengths that are used, in use, in a metrology tool 100. Generally, as used herein, opaque may mean a transmissivity of less than 1% for a wavelength range of 400-1600 nm. For example, generally, as used herein, opaque may mean a transmissivity of less than 0.1% for a wavelength range of 400-1600 nm. For example, generally, as used herein, opaque may mean a transmissivity of less than 0.1% for a wavelength range of 400-900 nm. For example, generally, as used herein, opaque may mean a transmissivity of less than 0.01% for a wavelength range of 400-1600 nm. For example, generally, as used herein, opaque may mean a transmissivity of less than 0.01% for a wavelength range of 400-900 nm.

The module 110 described above may comprise a generally transmissive carrier layer (for example formed from a glass material). The opaque portions of the module 110 described above may be achieved by applying a black paint (or similar material) to portions of such a generally transmissive carrier layer so as to block radiation incident on such portions.

The embodiment 200 shown in Figure 9 further comprises a second portion 214, the second portion 214 being adjacent the first portion 212 and offset from the first portion 214 in a first direction (the x' direction in Figure 9). Furthermore, a transmissivity of the second portion 214 in the first direction (the x' direction) is dependent on wavelength such that for at least a part of the second portion 214 a minimum wavelength that is transmitted by the second portion 214 increases with distance from the first portion 212 in the first direction (the x' direction).

Advantageously, with such an arrangement smaller wavelengths will only be transmitted by the second portion 214 for a small range in the first direction (i.e. will have a smaller aperture) whereas larger wavelengths will be transmitted by the second portion 214 for a larger range in the first direction (i.e. will have a larger aperture). Therefore, as explained further below, if the first direction is aligned with the dual (Fourier transformed) direction to the shearing direction of the target then the transmissivity properties of the second portion 214 will mean that an appropriate aperture can be provided so as to avoid overlap between the zeroth and first order beams for a range of illumination radiation wavelengths.

The embodiment 200 shown in Figure 9 further comprises a third portion 216, the third portion 216 being adjacent the first portion 212 and offset from the first portion 212 in a second direction (the y' direction in Figure 9). A transmissivity of the third portion in the second direction (the y' direction) is dependent on wavelength such that for at least a part of the third portion 216 a minimum wavelength that is transmitted by the third portion 216 increases with distance from the first portion 212 in the second direction (the y' direction).

Advantageously, this allows the module 110 to measure overlay in two directions (the first direction and the second direction) simultaneously (by simultaneously illuminating marks having shearing directions that correspond to the Fourier transform coordinates of the first and second direction). The second direction (y' direction) may be generally perpendicular to the first direction (x' direction).

The embodiment 200 shown in Figure 9 further comprises a fourth portion 218 that is generally opaque.

The fourth portion 218 is adjacent to the second portion 214 and offset from the second portion 214 in the second direction (y' direction). Furthermore, a transmissivity of the second portion 214 in the second direction (y' direction) is dependent on wavelength such that for at least a part of the second portion 214 a minimum wavelength that is transmitted by the second portion 214 increases with distance from the fourth portion 218 in the second direction (the y' direction).

The fourth portion 218 is adjacent to the third portion 216 and offset from the third portion 216 in the first direction (x' direction). A transmissivity of the third portion 216 in the first direction (x' direction) is dependent on wavelength such that for at least a part of the third portion 216 a minimum wavelength that is transmitted by the third portion 216 increases with distance from the fourth portion 218 in the first direction (the x' direction).

In some embodiments, the module 110 may comprise a plurality of adjacent filters provided as separate layers and stacked in a direction of an optical axis of the metrology tool 100. The filters may each comprise a pass filter that transmits radiation with a wavelength above a threshold value and which blocks radiation with a wavelength below the threshold value. Each of the plurality of filters may have a different threshold value. The filters may partially overlap in a plane that is generally perpendicular to the optical axis of the metrology tool 100 (i.e. the plane of Figure 9). An advantage of such an arrangement is that the transition between each of the adjacent regions 220, 222, 224, 226a, 226b in a plane that is generally perpendicular to the optical axis of the metrology tool 100 (i.e. the plane of Figure 9) can potentially be sharper than such transitions would be without such partial overlap in a plane that is generally perpendicular to the optical axis of the metrology tool 100. This is because the plurality of filters can partially overlap in the plane that is generally perpendicular to the optical axis of the metrology tool 100 (since the filters are disposed at different positions in a direction of an optical axis of the metrology tool 100).

For example, a first filter layer may be provided having the transmission characteristics of the first region 220 (see, for example, Figure 10A). Such a layer may be provided over at least the region of the module 110 corresponding to the first aperture 240 (see Figure 11D), i.e. over the first regions 220 (see Figure 9). In some embodiments, the first filter layer is provided only over the region of the module 110 corresponding to the first regions 220 (see Figure 9). In some other embodiments, the first filter layer can be provided over the entire region of the module 110 corresponding to the fourth aperture 246 (see Figure 11D) since the threshold value for the first region 220 is lower than the threshold values for the second, third and fourth regions 222, 224, 226a, 226b. The first filter layer may, for example, be applied onto a support substrate.

A second filter layer may be provided having the transmission characteristics of the second region 222 (see, for example, Figure 10B). Such a layer may be provided over at least the second regions 222 (see Figure 9). In some embodiments, the second filter layer is provided only over the region of the module 110 corresponding to the second regions 222 (see Figure 9). In some other embodiments, the second filter layer can be provided over the entire region of the module 110 corresponding to the second, third and fourth regions 222, 224, 226a, 226b since the threshold value *λ*₁ for the second region 222 is lower than the threshold values for the third and fourth regions 224, 226a, 226b. The second filter layer may, for example, be applied onto the first filter layer, which may be supported by a support substrate.

A third filter layer may be provided having the transmission characteristics of the third region 224 (see, for example, Figure 10C). Such a layer may be provided over at least the third regions 224 (see Figure 9). In some embodiments, the third filter layer is provided only over the region of the module 110 corresponding to the third regions 224 (see Figure 9). In some other embodiments, the third filter layer can be provided over the entire region of the module 110 corresponding to the third and fourth regions 224, 226a, 226b since the threshold value *λ*₂ for the third region 224 is lower than the threshold value for the fourth region 226a, 226b. The third filter layer may, for example, be applied onto the second filter layer, which may be supported by the first filter layer and the support substrate.

A fourth filter layer may be provided having the transmission characteristics of the fourth region 226a, 226b (see, for example, Figure 10D). Such a layer may be provided over only the fourth regions 226a, 226b (see Figure 9). Such a layer can be provided over the entire region of the module 110 corresponding to the fourth region 226a, 226b. The fourth filter layer may, for example, be applied onto the third filter layer, which may be supported by the second filter layer, the first filter layer and the support substrate.

Advantageously, by overlapping the plurality of filter layers in a plane that is generally perpendicular to the optical axis of the metrology tool 100, the transition between each of the adjacent regions 220, 222, 224, 226a, 226b in a plane that is generally perpendicular to the optical axis of the metrology tool 100 (i.e. the plane of Figure 9) can be sharper than it would be if the plurality of filter layers do not overlap at all in a plane that is generally perpendicular to the optical axis of the metrology tool 100.

In some embodiments, the module 110 for at least partially defining an aperture of the metrology tool 100 may comprise a plurality of filters arranged substantially in the same plane in a direction generally perpendicular to an optical axis of the metrology tool. That is, each filter may have (in a plane that is generally perpendicular to the optical axis of the metrology tool 100) the same shape as one of the four different regions 220, 222, 224, 226a, 226b shown in Figure 9. An advantage of such an arrangement is that all of the plurality of filters can be disposed in the pupil plane of the metrology tool and, therefore, the edges of the aperture can be sharp even if the optical system has a relatively small depth of focus. The plurality of filters may all be provided on a common support layer. The filters may each comprise a pass filter that transmits radiation with a wavelength above a threshold value and which blocks radiation with a wavelength below the threshold value. Each of the plurality of filters may have a different threshold value.

Some embodiments of the present disclosure relate to module 110 for use in the new metrology tool 100 shown in Figure 8 and described above. In general, the module 110 may have any of the features discussed above.

Some embodiments of the present disclosure relate to a new module 110 for at least partially defining an aperture in a metrology tool 100.

According to some embodiments, the new module 110 is configured such that a size and/or shape of the aperture defined by the module 110 is dependent on a wavelength of the received radiation. Such a module 110 for a metrology tool 100 is advantageous as it allows for different apertures to be automatically selected when illuminated with different wavelengths of radiation. That is, once an illuminating wavelength has been selected an appropriate aperture is automatically selected by virtue of the transmission characteristics of the module.

In some embodiments, the new module 110 is configured such that at least two different apertures can defined by the module 110, the aperture that is defined being dependent on the wavelength of the received radiation. It will be appreciated that the module 110 may be configured such that any number of different apertures can defined by the module 110. In general, the module 110 may be configured such that a number of different apertures that can defined by the module 110 is equal to (or greater than) a number of different wavelengths that, in use, will be used with each target within a metrology tool 100 that the module 110 is used in.

In some embodiments, the module 110 is configured such that a finite number of different apertures can defined by the module 110. For example, the different apertures may each be at least partially defined by a number of discrete steps in a minimum wavelength that is transmitted by the module in one or more directions.

Alternatively, the module 110 may be configured such that a continuum of different apertures can defined by the module. For example, the different apertures may each be at least partially defined a gradient in a minimum wavelength that is transmitted by the module in one or more directions.

In some embodiments, the module 110 is configured such that at least two different apertures that can be defined by the module 110 at least partially overlap.

For example, in some embodiments one of the (smaller) apertures may completely overlap with another one of the (larger apertures). That is, the smaller aperture may comprise a first region of the module 110 and the larger aperture may comprise the first region plus an additional, second region of the module 110.

In some embodiments, the module 110 is configured such that a plurality of different nested apertures can be defined. In some embodiments, the module is configured such that a plurality of different apertures can be defined, comprising (in ascending order) a first aperture, a second aperture and so on and wherein each aperture from the second aperture onwards comprises the same region of the module as the next smallest aperture plus an additional region.

In some embodiments, the module 110 may be configured such that a size of the aperture defined by the module 110 increases with increasing wavelength.

This is advantageous since, as discussed below, in some metrology tools it is generally desirable to use a larger (smaller) aperture with larger (smaller) wavelengths.

In some embodiments, the module 110 may comprise a generally planar body. It will be appreciated that a generally planar body is intended to mean a body having two larger dimensions and one smaller dimension. The two larger dimensions may define a plane of the body.

In some embodiments, the module 110 comprises a first portion 212 that is generally opaque. This is advantageous when the module 110 is disposed in a first (illumination) pupil plane 112 of a metrology tool 100 and it is desirable to be able to separate one or more higher order diffraction beams from the zeroth order diffraction beam in a second (measurement) pupil plane 134 of the metrology tool 100 (that is optically downstream of the target). Since the first portion 212 is generally opaque, there will be corresponding portions of the second pupil plane 134 that are not illuminated by the zeroth order diffraction beam.

It will be appreciated that the first portion being generally opaque may be intended to mean that it does not transmit a range of radiation wavelengths that are used, in use, in a metrology tool 100.

In some embodiments, the module 110 further comprises a second portion 214, the second portion 214 being adjacent the first portion 212 and offset from the first portion 212 in a first direction (e.g. the x' direction). A transmissivity of the second portion 214 in the first direction may be dependent on wavelength such that for at least a part of the second portion 214 a minimum wavelength that is transmitted by the second portion 214 increases with distance from the first portion 212 in the first direction.

Advantageously, with such an arrangement smaller wavelengths will only be transmitted by the second portion 214 for a small range in the first direction (i.e. will have a smaller aperture) whereas larger wavelengths will be transmitted by the second portion 214 for a larger range in the first direction (i.e. will have a larger aperture). Therefore, as explained further below, if the first direction is aligned with the dual (Fourier transformed) direction to the shearing direction of the target then the transmissivity properties of the second portion 214 will mean that an appropriate aperture can be provided so as to avoid overlap between the zeroth and first order beams for a range of illumination radiation wavelengths.

In some embodiments, the module 110 further comprises a third portion 216, the third portion 216 being adj acent the first portion 212 and offset from the first portion 212 in a second direction (e.g. the y' direction). A transmissivity of the third portion 216 in the second direction may be dependent on wavelength such that for at least a part of the third portion 216 a minimum wavelength that is transmitted by the third portion 216 increases with distance from the first portion 212 in the second direction.

Advantageously, this may allow the module to measure overlay in two directions (the first direction and the second direction) simultaneously. The second direction may be generally perpendicular to the first direction.

In some embodiments, the module 110 further comprises a fourth portion 218 that is generally opaque.

The fourth portion 218 may be adjacent to the second portion 214 and offset from the second portion 214 in the second direction (e.g. the y' direction). A transmissivity of the second portion 214 in the second direction may be dependent on wavelength such that for at least a part of the second portion 214 a minimum wavelength that is transmitted by the second portion 214 increases with distance from the fourth portion 218 in the second direction.

The fourth portion 218 may be adjacent to the third portion 216 and offset from the third portion 216 in the first direction (e.g. the x' direction). A transmissivity of the third portion 216 in the first direction may be dependent on wavelength such that for at least a part of the third portion 216 a minimum wavelength that is transmitted by the third portion 216 increases with distance from the fourth portion 218 in the first direction.

In some embodiments, module 110 may comprise a plurality of adj acent filters provided as separate layers and stacked in a direction generally perpendicular to a plane of the module 110. The filters may each comprise a pass filter that transmits radiation with a wavelength above a threshold value and which blocks radiation with a wavelength below the threshold value. Each of the plurality of filters may have a different threshold value. The filters may partially overlap in a plane of the module 110.

Alternatively, the module 110 may comprise a plurality of filters arranged substantially in the same plane. The plurality of filters may be provided on a common support layer. The filters may each comprise a pass filter that transmits radiation with a wavelength above a threshold value and which blocks radiation with a wavelength below the threshold value. Each of the plurality of filters may have a different threshold value.

Some embodiments of the present disclosure relate to a new module 110 for at least partially defining an aperture in a metrology tool 100 that comprises at least a first portion 212 and a second portion 214, the second portion 214 being adjacent the first portion 212 and offset from the first portion 212 in a first direction. The first portion 212 may be generally opaque and a transmissivity of the second portion 214 in the first direction may be dependent on wavelength such that for at least a part of the second portion 214 a minimum wavelength that is transmitted by the second portion 214 increases with distance from the first portion 212 in the first direction. Such a module is advantageous, as now discussed.

In use, the module 110 may be used in a metrology tool 100. Such a metrology tool 100 may, for example, comprise a scatterometer for use in measuring targets on an object (for example a lithographic wafer W). For example, it may comprise a dark field scatterometer. The module 110 may be used for defining a shape and extent of a radiation beam in an illumination pupil plane of the metrology tool 100. That is, the module may be provided optically upstream of the object W under investigation and in a Fourier transform plane to that of the object (the plane of the object may be referred to as a field plane). The module 110 may be referred to as an aperture plate.

It will be appreciated that the pupil plane of the metrology tool is intended to mean a plane that is a Fourier transform plane of a beam spot region or field plane of the metrology tool. That is, the intensity distribution of the radiation in the beam spot region is a Fourier transform of the intensity distribution of the radiation in the illumination pupil plane. It will be appreciated that all rays from any given point in the pupil plane are mapped onto substantially the entire beam spot region. Put differently, the rays from any given point in the pupil plane illuminate the entire field of view (FOV) of the metrology tool. Similarly, a single point in the beam spot region maps onto substantially the entire pupil plane. The intensity distribution of the radiation in a pupil plane characterizes the angular distribution of radiation in a field plane (i.e. the beam spot region).

Within such a scatterometer a target (for example a periodic structure or grating) may be illuminated with a radiation beam 152. The radiation will scatter from the target forming a plurality of diffraction beams 154. At least a portion of scattered radiation (comprising at least some of the diffraction beams) may be collected by collection optics 120, 130. As described above, the module 110 may be used in an illumination pupil 112 of the tool 100 so as to define an aperture or illumination mode of the tool used to illuminate the target. In a second pupil plane 134 that is optically downstream of the target and conjugate to the plane 112 of the module 110, there will be a contribution from a zeroth order diffraction beam, which will illuminate a portion of the second pupil plane 134 that is optically conjugate to the second portion 214 of the pupil 112. The zeroth order diffraction beam will generally not illuminate a portion of the second pupil plane 134 that is optically conjugate to the first portion 212 of the module 110.

In addition to the contribution to the second pupil plane 134 from the zeroth order diffraction beam there will, in general, also be a contribution from each of the higher order diffraction beams (or at least each of the higher order diffraction beams that is accepted by the numerical aperture of the collection optics 120, 130). The contribution to the second pupil plane 134 from a higher order diffraction beam will in general be a copy of the contribution from the zeroth order diffraction beam which has been (a) shifted in a shearing direction of the target; and (b) weighted by a diffraction efficiency for that diffraction order of that target. Such diffraction efficiencies are, in general, dependent on the topology of the target, in particular the shape of the unit cell.

An amount by which the contribution to the second pupil plane 134 from a higher order diffraction beam is shifted relative to the contribution from the zeroth order diffraction beam is dependent on a pitch of the target and the wavelength of the illumination radiation 152. For example, for a target with pitch p and illumination radiation 152 with a wavelength λ, the angular separation between the zeroth order diffraction beam and the first order diffraction beams is sin⁻¹(λ/p) (and a shift in the pupil plane 134 will be proportional to λ/p). Therefore, for a fixed pitch p, the larger the wavelength the larger the angular separation Δθ between the zeroth and first order diffraction beams.

It may be desirable within a metrology tool 100 to be able to separate the higher order diffraction beams from the zeroth order diffraction beam. This can be achieved by suitable selection optics 132 disposed in or near the second pupil plane 134 as long as the higher order diffraction beams do not overlap with the zeroth order diffraction beams in the second pupil plane 134. Therefore, it may be desirable for there to be sufficient separation between the higher order diffraction beams from the zeroth order diffraction beam in the second pupil plane such that the higher order diffraction beams overlap with a portion of the second pupil plane 134 that is optically conjugate to the first portion 212 of the module 110.

The response of measurements (for example overlay measurements) made in scatterometers is typically sensitive to the wavelength of radiation used by the scatterometer. Furthermore, it is desirable to separate out any background signal due to this wavelength dependence. For this reason, these scatterometry metrology tools often make a plurality of separate, sequential measurements of each metrology mark or target with different wavelengths of radiation, which are then combined. The specific wavelengths (and bandwidths) are typically dependent on the specific lithographic process or recipe and are typically optimized for a given process so as to maximize the response to overlay errors.

In existing metrology tools a plurality of different aperture plates may be provided, each one suitable for use with a different combination of target pitch and wavelength. For a given target, the pitch is fixed and therefore when different wavelengths are used for measurements the shift of the first order diffraction beams (relative to the zeroth order beams) in the second pupil plane 134 will vary. As a result, with existing arrangements, in order to avoid overlap between the zeroth and first order beams either (a) the same aperture plate (i.e. the same pupil) is used for all wavelengths, the aperture being sufficiently small so as to avoid overlap between the zeroth and first order beams; or (b) the aperture plate may be swapped for another aperture plate (for example a plurality of aperture plates may be provided on a wheel such that each may be placed in the beam path, one at a time). Disadvantageously, solution (a) means that a smaller than optimal aperture is used for some wavelengths and this results in a loss of throughput. Similarly, solution (b) results in a loss of throughput as it takes a non-zero amount of time to swap the aperture plates.

Advantageously, in some embodiments, the module 110 comprises a second portion 214 having a transmissivity in the first direction that is dependent on wavelength such that for at least a part of the second portion 214 a minimum wavelength that is transmitted by the second portion 214 increases with distance from the first portion 212 in the first direction. Therefore, smaller wavelengths will only be transmitted by the second portion 214 for a small range in the first direction (i.e. will have a smaller aperture) whereas larger wavelengths will be transmitted by the second portion 214 for a larger range in the first direction (i.e. will have a larger aperture). Therefore, if the first direction is aligned with the dual (Fourier transformed) direction to the shearing direction of the target then the transmissivity properties of the second portion 214 will mean that an appropriate aperture can be provided so as to avoid overlap between the zeroth and first order beams for a range of illumination radiation wavelengths.

Such embodiments may also comprise the third and fourth portions 216, 218 of the module 110 described above. However, it will be appreciated that the third and fourth portions 216, 218 are optional (and may allow for simultaneous overlay measurements in two different directions).

In some embodiments, the module 110 comprises a generally planar body. It will be appreciated that a generally planar body is intended to mean a body having two larger dimensions and one smaller dimension. The two larger dimensions may define a plane of the body. The first, second, third and fourth portions 212, 214, 216, 218 may be portions of the plane of the body.

Alternatively, in some embodiments the module 110 may comprise a plurality of bodies. In use, each such body may be disposed in a different plane, all of the planes being optically conjugate (for example the planes may all be pupil planes of a metrology tool). For example, the first portion 212 may be defined on a first body and the second portion 214 may be defined on a second body.

In an example related to figures 9 until 11 we disclose a module for at least partially defining an aperture in a metrology tool on an optical path between a light input and a light output, the module comprising: the light input for receiving an incoming light beam; the light output for outputting a shaped light beam; a first transmissive region being configured to transmit light in a first spectral range; a second transmissive region being configured to transmit light in a second spectral range, wherein the first spectral range and the second spectral range are selected such that, if light of a first wavelength band of the incoming light beam is received by the light input, a first effective aperture is formed to provide the shaped light beam, and if light of a second wavelength band of the incoming light beam is received by the light input, a second effective aperture is formed to provide the shaped light beam.

The light input is for receiving an incoming light beam. The incoming light beam can be a broadband light source. The broadband light source can have wavelengths in for example a range of 400-1600 nm, 600-1600 nm, 800-1600 nm, 450-900 nm, 600-900 nm or 800-900 nm. The light output is for outputting a shaped light beam, where the shaped light beam gets shaped by the module as described. The light input and light output are at different sides of the module perpendicular to the optical path. The incoming light beam can also be referred to as a radiation beam coming from a radiation source. As described above this radiation beam may be generally circular. The shaped light beam can also be referred to as a modified radiation beam modified by blocking radiation in some portions in a plane of the module, as described above. For example, in a cross sectional view along the optical path the modified or shaped beam can have two square regions after modification.

A first transmissive region is configured to transmit light in a first spectral range. This first region can take any shape, such as for example rectangular, square, triangular, circular, oval, diamond, or any other shape derived or combined from these shapes. Similarly a second transmissive region is configured to transmit light in a second spectral range. As described for the first region, also this second region can take any shape. Next to shape, also the size of the transmissive regions can vary, where the size is defined by the dimensions of the particular shape. The different regions can have a substantially similar size, or have a substantially different size. It will be appreciated that the described transmissive regions can also be described a plurality of regions having different transmission properties as described above.

The spectral range in which a transmissive region can be configured to transmit light can for example be defined in a range of 400-1600 nm, 600-1600 nm, 800-1600 nm, 450-900 nm, 600-900 nm or 800-900 nm. For example, a first region can transmit light with wavelengths ranging from approximately 400-900 nm, and a second region can transmit light with wavelengths ranging from approximately 600-900 nm. In another example, a first region can transmit light with wavelengths ranging from approximately 400-405 nm, and a second region can transmit light with wavelengths ranging from approximately 400-410 nm. Or, in another example, a first region can transmit light with wavelengths ranging from approximately 400-405 nm, and a second region can transmit light with wavelengths ranging from approximately 406-410 nm. It will be appreciated that spectral range can also be described as transmission spectra as further described above.

By transmitting light in a selected spectral range an effective aperture is formed that shapes the light beam, and as such provides a shaped light beam for outputting.

In the description above two transmissive regions were described, however it can be imagined more than two transmissive regions are provided, each with their spectral range selected such that an effective aperture is formed to provide the shaped light beam.

Further embodiments are disclosed in the subsequent list of numbered clauses:
1. A metrology tool for determining one or more parameters of interest of a structure on an object, the metrology tool comprising:
   a module for at least partially defining an aperture which is positionable so as to receive a radiation beam and to transmit a modified radiation beam;
   projection optics arranged to project modified radiation output by the module onto a beam spot region in which the structure is positionable;
   detection optics arranged to receive at least a portion of radiation scattered by the structure; and
   a detector operable to determine one or more parameters from the received scattered radiation;
   wherein the module is configured such that a size and/or shape of the aperture defined by the module is dependent on a wavelength of the received radiation.
2. The metrology tool of clause 1 wherein the module is positionable in a pupil plane of the metrology tool.
3. The metrology tool of clause 1 or clause 2 further comprising a beam-modifying module arranged to control one or more properties of the radiation beam.
4. The metrology tool of any preceding clause wherein the module is configured such that at least two different apertures can defined by the module, the aperture that is defined being dependent on the wavelength of the received radiation.
5. The metrology tool of any preceding clause wherein the module is configured such that a finite number of different apertures can defined by the module.
6. The metrology tool of any preceding clause wherein the module is configured such that at least two different apertures that can be defined by the module at least partially overlap.
7. The metrology tool of any preceding clause wherein the module is configured such that a size of the aperture defined by the module increases with increasing wavelength.
8. The metrology tool of any preceding clause wherein the module comprises a generally planar body.
9. The metrology tool of any preceding clause wherein the module comprises a first portion that is generally opaque.
10. The metrology tool of clause 9 wherein the module further comprises a second portion, the second portion being adjacent the first portion and offset from the first portion in a first direction; wherein a transmissivity of the second portion in the first direction is dependent on wavelength such that for at least a part of the second portion a minimum wavelength that is transmitted by the second portion increases with distance from the first portion in the first direction.
11. The metrology tool of clause 9 or clause 10 wherein the module further comprises a third portion, the third portion being adjacent the first portion and offset from the first portion in a second direction; and wherein a transmissivity of the third portion in the second direction is dependent on wavelength such that for at least a part of the third portion a minimum wavelength that is transmitted by the third portion increases with distance from the first portion in the second direction.
12. The metrology tool of any one of clauses 9 to 11 wherein the module further comprises a fourth portion that is generally opaque.
13. The metrology tool of clause 12 when dependent on clause 11 wherein the fourth portion is adjacent to the second portion and offset from the second portion in the second direction and wherein a transmissivity of the second portion in the second direction is dependent on wavelength such that for at least a part of the second portion a minimum wavelength that is transmitted by the second portion increases with distance from the fourth portion in the second direction.
14. The metrology tool of clause 12 or clause 13 when dependent on clause 11 wherein the fourth portion is adjacent to the third portion and offset from the third portion in the first direction and wherein a transmissivity of the third portion in the first direction is dependent on wavelength such that for at least a part of the third portion a minimum wavelength that is transmitted by the third portion increases with distance from the fourth portion in the first direction
15. The metrology tool of any preceding clause wherein the module comprises a plurality of adjacent filters provided as separate layers and stacked in a direction of an optical axis of the metrology tool.
16. The metrology tool of one of clauses 1 to 14 wherein the module comprises a plurality of filters arranged substantially in the same plane in a direction generally perpendicular to an optical axis of the metrology tool.
17. The metrology tool of any preceding clause comprising a plurality of modules according to any preceding clause.
18. The metrology tool of any preceding clause further comprising a radiation source operable to produce the radiation beam that is received by the module.
19. The metrology tool of any preceding clause further comprising a support for supporting an object such that it is positionable so as to receive the modified radiation from the module.
20. The metrology tool of clause 19 further comprising a movement mechanism operable to cause relative movement of the support and the modified radiation beam.
21. A module for use in the metrology tool of any preceding clause.
22. A module for at least partially defining an aperture in a metrology tool wherein the module is configured such that a size and/or shape of the aperture defined by the module is dependent on a wavelength of the received radiation.
23. The module of clause 22 wherein the module is configured such that at least two different apertures can defined by the module, the aperture that is defined being dependent on the wavelength of the received radiation.
24. The module of clause 22 or clause 23 wherein the module is configured such that a finite number of different apertures can defined by the module.
25. The module of any one of clauses 22 to 24 wherein the module is configured such that at least two different apertures that can be defined by the module at least partially overlap.
26. The module of any preceding clause wherein the module is configured such that a size of the aperture defined by the module increases with increasing wavelength.
27. The module of any one of clauses 22 to 26 wherein the module comprises a generally planar body.
28. The module of any one of clauses 22 to 27 wherein the module comprises a first portion that is generally opaque.
29. The module of clause 28 further comprising a second portion, the second portion being adjacent the first portion and offset from the first portion in a first direction; wherein a transmissivity of the second portion in the first direction is dependent on wavelength such that for at least a part of the second portion a minimum wavelength that is transmitted by the second portion increases with distance from the first portion in the first direction.
30. The module of clause 28 or clause 29 wherein the module further comprises a third portion, the third portion being adjacent the first portion and offset from the first portion in a second direction; and wherein a transmissivity of the third portion in the second direction is dependent on wavelength such that for at least a part of the third portion a minimum wavelength that is transmitted by the third portion increases with distance from the first portion in the second direction.
31. The module of any one of clauses 28 to 30 wherein the module further comprises a fourth portion that is generally opaque.
32. The module of clause 31 when dependent on clause 30 wherein the fourth portion is adjacent to the second portion and offset from the second portion in the second direction and wherein a transmissivity of the second portion in the second direction is dependent on wavelength such that for at least a part of the second portion a minimum wavelength that is transmitted by the second portion increases with distance from the fourth portion in the second direction.
33. The module of clause 30 or clause 31 when dependent on clause 29 wherein the fourth portion is adjacent to the third portion and offset from the third portion in the first direction and wherein a transmissivity of the third portion in the first direction is dependent on wavelength such that for at least a part of the third portion a minimum wavelength that is transmitted by the third portion increases with distance from the fourth portion in the first direction
34. The module of any one of clauses 22 to 33 comprising a plurality of adjacent filters provided as separate layers and stacked in a direction generally perpendicular to a plane of the module.
35. The module of any one of clauses 22 to 33 comprising a plurality of filters arranged substantially in the same plane.
36. A module for at least partially defining an aperture in a metrology tool, the module comprising:
   a first portion; and
   a second portion, the second portion being adjacent the first portion and offset from the first portion in a first direction;
   wherein the first portion is generally opaque;
   wherein a transmissivity of the second portion in the first direction is dependent on wavelength such that for at least a part of the second portion a minimum wavelength that is transmitted by the second portion increases with distance from the first portion in the first direction.
37. The module of clause 36 further comprising a third portion, the third portion being adjacent the first portion and offset from the first portion in a second direction; and wherein a transmissivity of the third portion in the second direction is dependent on wavelength such that for at least a part of the third portion a minimum wavelength that is transmitted by the third portion increases with distance from the first portion in the second direction.
38. The module of any one of clauses 36 to 37 further comprising a fourth portion that is generally opaque.
39. The module of clause 38 when dependent on clause 37 wherein the fourth portion is adjacent to the second portion and offset from the second portion in the second direction and wherein a transmissivity of the second portion in the second direction is dependent on wavelength such that for at least a part of the second portion a minimum wavelength that is transmitted by the second portion increases with distance from the fourth portion in the second direction.
40. The module of clause 38 or clause 39 when dependent on clause 37 wherein the fourth portion is adjacent to the third portion and offset from the third portion in the first direction and wherein a transmissivity of the third portion in the first direction is dependent on wavelength such that for at least a part of the third portion a minimum wavelength that is transmitted by the third portion increases with distance from the fourth portion in the first direction.
41. The module of any one of clauses 36 to 40 wherein the module comprises a generally planar body.
42. A module for at least partially defining an aperture in a metrology tool on an optical path between a light input and a light output, the module comprising:
   - the light input for receiving an incoming light beam;
   - the light output for outputting a shaped light beam;
   - a first transmissive region being configured to transmit light in a first spectral range;
   - a second transmissive region being configured to transmit light in a second spectral range, wherein the first spectral range and the second spectral range are selected such that,
      - if light of a first wavelength band of the incoming light beam is received by the light input, a first effective aperture is formed to provide the shaped light beam,
   - and if light of a second wavelength band of the incoming light beam is received by the light input, a second effective aperture is formed to provide the shaped light beam.

Although specific reference is made to "metrology apparatus / tool / system" or "inspection apparatus / tool / system", these terms may refer to the same or similar types of tools, apparatuses or systems. For example, the inspection or metrology apparatus that comprises an embodiment of the invention may be used to determine characteristics of structures on a substrate or on a wafer. For example, the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A module for at least partially defining an aperture in a metrology tool wherein the module is configured such that a size and/or shape of the aperture defined by the module is dependent on a wavelength of the received radiation.

2. The module of claim 1, the module comprising:
- a light input for receiving an incoming light beam;
- a light output for outputting a shaped light beam;
- an optical path between the light input and the light output;
- a first transmissive region being configured to transmit light in a first spectral range;
- a second transmissive region being configured to transmit light in a second spectral range, wherein the first spectral range and the second spectral range are selected such that,
- if light of a first wavelength band of the incoming light beam is received by the light input, a first effective aperture is formed to provide the shaped light beam,
- and if light of a second wavelength band of the incoming light beam is received by the light input, a second effective aperture is formed to provide the shaped light beam.

3. A metrology tool for determining one or more parameters of interest of a structure on an object, the metrology tool comprising:
the module according to claim 1 or claim 2 which is configured to be positionable so as to receive a radiation beam and to transmit a modified radiation beam;
projection optics arranged to project modified radiation output by the module onto a beam spot region in which the structure is positionable;
detection optics arranged to receive at least a portion of radiation scattered by the structure; and
a detector operable to determine one or more parameters from the received scattered radiation;

4. The metrology tool of claim 3 wherein the module is configured to be positionable in a pupil plane of the metrology tool.

5. The metrology tool of claim 3 or claim 4 further comprising a beam-modifying module arranged to control one or more properties of the radiation beam.

6. The metrology tool of any preceding claim wherein the module is configured such that at least two different apertures can defined by the module.

7. The metrology tool of any preceding claim wherein the module is configured such that a size of the aperture defined by the module increases with increasing wavelength.

8. The metrology tool of any preceding claim wherein the module comprises a first portion that is generally opaque.

9. The metrology tool of claim 8 wherein the module further comprises a second portion, the second portion comprising the first and/or second transmissive region, the second portion being adjacent the first portion and offset from the first portion in a first direction; wherein a transmissivity of the second portion in the first direction is dependent on wavelength such that for at least a part of the second portion a minimum wavelength that is transmitted by the second portion increases with distance from the first portion in the first direction.

10. The metrology tool of claim 8 or claim 9 wherein the module further comprises a third portion, the third portion being adjacent the first portion and offset from the first portion in a second direction; and wherein a transmissivity of the third portion in the second direction is dependent on wavelength such that for at least a part of the third portion a minimum wavelength that is transmitted by the third portion increases with distance from the first portion in the second direction.

11. The metrology tool of any one of claims 8 to 10 wherein the module further comprises a fourth portion that is generally opaque.

12. The metrology tool of claim 11 when dependent on claim 10 wherein the fourth portion is adjacent to the second portion and offset from the second portion in the second direction and wherein a transmissivity of the second portion in the second direction is dependent on wavelength such that for at least a part of the second portion a minimum wavelength that is transmitted by the second portion increases with distance from the fourth portion in the second direction.

13. The metrology tool of claim 11 or claim 12 when dependent on claim 10 wherein the fourth portion is adjacent to the third portion and offset from the third portion in the first direction and wherein a transmissivity of the third portion in the first direction is dependent on wavelength such that for at least a part of the third portion a minimum wavelength that is transmitted by the third portion increases with distance from the fourth portion in the first direction

14. The metrology tool of any preceding claim wherein the module comprises a plurality of adjacent filters provided as separate layers and stacked in a direction of an optical axis of the metrology tool.

15. The metrology tool of one of claims 3 to 14 wherein the module comprises a plurality of filters arranged substantially in the same plane in a direction generally perpendicular to an optical axis of the metrology tool.
